# EUROPÄISCHE PATENTSCHRIFT

(11) **EP 2 661 768 B1**
(45) Veröffentlichungstag und Bekanntmachung des Hinweises auf die Patenterteilung: **04.03.2020**
(21) Anmeldenummer: 12700463.8
(22) Anmeldetag: 04.01.2012
(51) Int. Cl.: H01L 21/332, H01L 29/74, H01L 29/10, H01L 31/111, H01L 29/167

(54) **VERFAHREN ZUR HERSTELLUNG EINES HALBLEITERBAUELEMENTS MIT EINEM LATERALEN WIDERSTANDSBEREICH**
METHOD OF MAKING A SEMICONDUCTOR COMPONENT COMPRISING A LATERAL RESISTIVE REGION
MÉTHODE DE FABRICATION D'UN COMPOSANT SEMI-CONDUCTEUR COMPRENANT UNE RÉGION RÉSISTIVE LATÉRALE

(30) Priorität: 05.01.2011 DE 102011002479
(43) Veröffentlichungstag der Anmeldung: 13.11.2013
(73) Patentinhaber: Infineon Technologies Bipolar GmbH & Co. KG, 59581 Warstein (DE)
(72) Erfinder: SCHULZE, Hans-Joachim, 82024 Taufkirchen (DE); KELLNER-WERDEHAUSEN, Uwe, 91359 Leutenbach (DE); BAUER, Kurt, 33142 Büren (DE)
(74) Vertreter: Lohmanns, Bernard
(86) Internationale Anmeldenummer: PCT/EP2012/050112
(87) Internationale Veröffentlichungsnummer: WO 2012/093146

(56) Entgegenhaltungen:
- DE-A1- 10 231 199
- DE-U- 7 245 023
- US-A- 3 611 066

## Beschreibung

Die vorliegende Erfindung betrifft ein Verfahren zur Herstellung eines Halbleiterbauelements mit wenigstens einem integrierten Lateralwiderstand.

Lateralwiderstände spielen bei Leistungshalbleiterbauelementen im Allgemeinen und bei Hochspannungsthyristoren im Besonderen eine große Rolle. Sie werden beispielsweise in Thyristorstrukturen mit so genannter Amplifying-Gate-Struktur implementiert, um die Stromanstiegsgeschwindigkeit beim Einschalten des Thyristors zu begrenzen. Insbesondere dienen die integrierten Lateralwiderstände in Thyristorstrukturen dem Zweck, den Strom durch eine oder mehrere der Amplifying-Gate-Stufen zu begrenzen, um damit einer möglichen Zerstörung des Bauelements unter extremen Schaltbedingungen vorzubeugen.

Ein Thyristor mit Amplifying-Gate-Struktur ist meist radialsymmetrisch aufgebaut. Der Hauptemitter ist konzentrisch um eine oder mehrere Hilfsemitter angeordnet, die über Hilfsemitterelektroden bzw. so genannte Amplifying-Gate-Elektroden kontaktiert sind. Zwischen einer oder mehreren dieser Amplifying-Gate-Elektroden kann ein integrierter Lateralwiderstand zum Schutz des Thyristors vorgesehen sein, der in einem eigens dafür vorgesehenen Widerstandsbereich angeordnet ist. Die Amplifying-Gate-Elektroden sind typischerweise kreisringförmig ausgebildet. Dadurch bedingt ist auch der integrierte Lateralwiderstand vorzugsweise von radialsymmetrischer Form.

Aus der DE 196 40 311 B4 ist ein Verfahren zur Herstellung eines Halbleiterbauelements bekannt, bei dem der Widerstand, der beispielsweise in einer zwischen einer zweiten und einer dritten Amplifying-Gate-Stufe gelegenen p-Basis dadurch gezielt eingestellt wird, dass am fertig prozessierten Thyristorpellet eine Bestrahlung mit hochenergetischen Teilchen durchgeführt wird. Die durch die Bestrahlung bedingten Defekte bewirken eine Reduzierung der Beweglichkeit der freien Ladungsträger im Halbleiterkörper und damit einen Anstieg des Widerstands. Nachteilig bei diesem Verfahren ist allerdings ein erheblicher Kostenaufwand, da die Bestrahlung nur mit speziell geeigneten Beschleunigern durchgeführt werden kann.

In der EP 0 472 880 B1 ist ebenfalls ein Verfahren zur Herstellung eines Halbleiterbauelements mit einem definierten Lateralwiderstand beschrieben. Es ist ein Thyristor mit Lateralwiderstand angegeben, dessen Widerstandsbereich eine definiert geringere Dotierungskonzentration als die ihn umgebende Schicht aufweist. Die integrierten Widerstände werden in den Halbleiterbauelementen allgemein durch Eindiffusion bzw. Implantation von Dotieratomen, beispielsweise Bor oder Aluminium, erzeugt. Die Steuerung des Widerstandswertes erfolgt im Fall des Einbringens der Dotieratome durch Ionenimplantation über die gewählte Dosis. Werden die Dotieratome durch Diffusion eingebracht, wird eine strukturierte Ätzung der Dotierschicht vorgeschlagen, um den Widerstand gezielt einzustellen. Das beschriebene Verfahren ermöglicht zwar die Erzeugung von Lateralwiderständen mit gut reproduzierbaren Widerstandswerten, nachteilig sind jedoch die bei der strukturierten Ätzung erzeugten Ätzstufen im Halbleiterkörper, da die Kantenbedeckung an den geätzten Stufen besonders hohe Anforderungen an nachfolgende fototechnische Schritte stellt. Bei der Ionenimplantation ist die relativ geringe Eindringtiefe der implantierten Atome von Nachteil.

Die US 3 611 066 A offenbart ein Halbleiterbauelement gemäß dem Oberbegriff des Anspruchs 1.

Vor diesem Hintergrund hat sich die vorliegende Erfindung die Aufgabe gestellt, ein Verfahren zur Herstellung eines Thyristors mit wenigstens einem integrierten Lateralwiderstand anzugeben, bei dem der Lateralwiderstand wohl definiert und zuverlässig hergestellt werden kann, der Widerstandswert gut reproduzierbar ist und bei dem der Lateralwiderstand mit minimalem prozesstechnischen Aufwand im Thyristor integrierbar ist.

Diese Aufgabe wird erfindungsgemäß durch ein Verfahren zur Herstellung eines Thyristors mit den Merkmalen nach Anspruch 1 gelöst. Weitere, besonders vorteilhafte Ausgestaltungen der Erfindung offenbaren die Unteransprüche.

Die Beschreibung charakterisiert und spezifiziert die Erfindung insbesondere im Zusammenhang mit den Figuren zusätzlich.

Der vorliegenden Erfindung liegt der Gedanke zugrunde, den Widerstand in einem Halbleiterbereich eines vorgegebenen Leitungstyps durch lokales Einbringen von Dotierstoffen eines anderen, zu dem erstgenannten Leitungstyp komplementären Leitungstyps gezielt zu verändern.

So wird bei dem erfindungsgemäßen Verfahren zur Herstellung eines Thyristors mit wenigstens einem integrierten Lateralwiderstand zunächst ein Halbleiterkörper aus einem dotierten Halbleitermaterial eines ersten Leitungstyps bereitgestellt. In den Halbleiterkörper wird von der Oberfläche her ein Dotierstoff eines zweiten Leitungstyps zur Bildung einer an die Oberfläche des Halbleiterkörpers angrenzenden, dotierten Basiszone des zweiten Leitungstyps eingebracht. Der zweite Leitungstyp des Dotierstoffs ist zum ersten Leitungstyp des Halbleiterkörpers komplementär. Bevorzugt erfolgt das Einbringen des Dotierstoffs des zweiten Leitungstyps beispielsweise mittels Diffusion und/oder Implantation.

Anschließend wird die Oberfläche des Halbleiterkörpers maskiert, wobei wenigstens eine Aussparung mit einer vorgegebenen Breite in die Maske derart eingebracht wird, dass ein Widerstandsbereich der Basiszone wenigstens teilweise freigelegt wird. Der Widerstandsbereich der Basiszone stellt hierbei den Bereich der Basiszone dar, in dem der integrierte Lateralwiderstand erzeugt wird. Die Maskierung erfolgt bevorzugt mit einem Maskenoxid und besonders bevorzugt mit einem thermisch erzeugten Maskenoxid, kann jedoch auch mit einem geeigneten Fotolack erfolgen, wobei die auf den Halbleiterkörper aufgebrachte Maske entsprechend den vorzusehenden Aussparungen beispielsweise fototechnisch strukturiert wird.

Der nicht von der Maske bedeckte, freigelegte Widerstandsbereich wird anschließend von der Oberfläche her mit einem Dotierstoff des ersten Leitungstyps, das heißt mit einem Dotierstoff, dessen Leitungstyp komplementär zu dem zweiten Leitungstyp der Basiszone ist, belegt. Bei diesem Schritt wird an der frei zugänglichen Oberfläche des Widerstandsbereichs eine dünne Belegungsschicht des ersten Leitungstyps mit hoher Dotierungskonzentration ausgebildet. Die Dotierstoffbelegung erfolgt bevorzugt mittels eines maskierten Diffusions- und/oder eines maskierten Implantationsverfahrens.

Nach der Belegung der freigelegten Widerstandsbereiche mit dem Dotierstoff des ersten Leitungstyps wird die dünne Belegungsschicht in einem anschließenden Eintreibschritt in den Widerstandsbereich, das heißt in die Basiszone des zweiten Leitungstyps, eingetrieben. Hierbei wird aus der dünnen Belegungsschicht mit hoher Dotierungskonzentration eine dickere Schicht mit einer geringeren Dotierungskonzentration gebildet. Durch das Eintreiben des Dotierstoffs des ersten Leitungstyps in den Widerstandsbereich der Basiszone des zweiten, zum ersten Leitungstyp komplementären Leitungstyps, wird die Leitfähigkeit der Basiszone in dem Widerstandsbereich gezielt verändert, insbesondere verringert, wodurch der Lateralwiderstand gebildet wird. Bevorzugt wird der Eintreibschritt durch Erhitzen des Halbleiterkörpers ausgeführt und erfolgt beispielsweise in oxidierender Atmosphäre bei Temperaturen größer oder etwa gleich 1200 °C für mehrere Stunden.

Der mit der Erfindung erzielbare Vorteil liegt insbesondere darin, dass die Widerstandswerte des Lateralwiderstands besser, das heißt genauer und zuverlässiger, eingestellt werden können. Darüber hinaus lässt sich das erfindungsgemäße Verfahren ohne großen Zusatzaufwand in bestehende Herstellungsprozesse von Halbleiterbauelementen integrieren. Da Ätzstufen bei der Herstellung des integrierten Lateralwiderstands gemäß der Erfindung vermieden werden, lassen sich außerdem wesentlich kleinere Strukturen im Widerstandsbereich des Halbleiterbauelements realisieren, beispielsweise wesentlich kleiner als 30 µm, was eine wesentlich gleichmäßigere Einstellung des differentiellen Widerstands ermöglicht. Die Größe des Widerstandswerts wird mit dem erfindungsgemäßen Verfahren besonders bevorzugt über die Breite der Maskenaussparung und/oder über die Eindringtiefe des Dotierstoffs des ersten Leitungstyps in den Widerstandsbereich des zweiten Leitungstyps bestimmt.

In einer vorteilhaften Ausgestaltung des erfindungsgemäßen Verfahrens wird die dünne Belegungsschicht des ersten Leitungstyps mit hoher Dotierungskonzentration von der Oberfläche des Halbleiterkörpers her in den Widerstandsbereich der Basiszone des zweiten Leitungstyps eindiffundiert. So lässt sich der Widerstandswert durch die Belegungskonzentration des Dotierstoffs sowie die gewählten Diffusionsparameter wie Temperatur und Diffusionsdauer in einfacher Weise einstellen. Die Belegung erfolgt beispielsweise über mehrere Stunden bei Temperaturen um etwa 1000 °C. Der wesentliche Vorteil der Belegung mittels Diffusion ist die einfache Integration in den Gesamtherstellungsprozess des Halbleiterbauelements.

In einer anderen vorteilhaften Ausgestaltung des erfindungsgemäßen Verfahrens wird die dünne Belegungsschicht des ersten Leitungstyps mit hoher Dotierungskonzentration von der Oberfläche des Halbleiterkörpers her in den Widerstandsbereich der Basiszone des zweiten Leitungstyps implantiert. Der wesentliche Vorteil der Implantation gegenüber der Diffusion liegt in einer genaueren Steuerung der Belegungskonzentration des Dotierstoffs.

Erfindungsgemäß wird die Dotierung der Basiszone des zweiten Leitungstyps in dem Widerstandsbereich teilweise von dem eingetriebenen Dotierstoff des ersten Leitungstyps kompensiert. Insbesondere werden die freien Ladungsträger der Basiszone des zweiten Leitungstyps in dem Widerstandsbereich teilweise durch die freien Ladungsträger des eingetriebenen Dotierstoffs des ersten Leitungstyps kompensiert. Das heißt, die Anzahl der durch die dotierte Basiszone bereitgestellten freien Ladungsträger wird verringert, wodurch die Leitfähigkeit der Basiszone verringert wird. Vorteilhafterweise wird durch die Teilkompensation kein pn-Übergang zwischen dem eingetriebenen Dotierstoff des ersten Leitungstyps und der dotierten Basiszone des zweiten Leitungstyps gebildet. Der Widerstandswert des Lateralwiderstands wird in diesem Fall im Wesentlichen durch die Anzahl der nicht kompensierten Ladungsträger der dotierten Basiszone des ersten Leitungstyps sowie durch die Breite der jeweils in die Maske eingebrachten Aussparung, die Anzahl der Aussparungen und die Tiefe des in den Widerstandsbereich eingetriebenen Dotierstoffs des ersten Leitungstyps bestimmt. Gemäß einer vorteilhaften Ausgestaltung des erfindungsgemäßen Verfahrens werden mehrere Aussparungen jeweils mit einer vorgegebenen Breite und in einem vorgegebenen Abstand zueinander in die Maske eingebracht. Hierdurch kann der Lateralwiderstand beispielsweise in radialer Richtung gezielt eingestellt werden, um die in dem Lateralwiderstand dissipierte Leistung über den gesamten Widerstandsbereich radial gleichmäßiger zu verteilen. Hierdurch kann eine lokale Überlastung und eine thermische Zerstörung des Lateralwiderstands bei hohen Strömen und/oder Spannungen infolge einer Ortsabhängigkeit des Widerstandswerts verhindert werden. Ein Verfahren zur Einstellung eines derartigen Lateralwiderstands ist beispielsweise in der anmeldereigenen Patentanmeldung DE 102 31 199 A1 beschrieben.

Weitere Merkmale und Vorteile der Erfindung ergeben sich aus den übrigen Ansprüchen sowie der folgenden Beschreibung von nicht einschränkend zu verstehenden Ausführungsbeispielen der Erfindung, die im Folgenden unter Bezugnahme auf die Zeichnung näher erläutert werden. In dieser Zeichnung zeigen schematisch:
Fig. 1 eine Teilschnittansicht einer Amplifying-Gate-Struktur eines Thyristors mit einem Widerstandsbereich und einem darin integrierten Lateralwiderstand, der nach dem erfindungsgemäßen Verfahren hergestellt ist,
Fig. 2 den vergrößert dargestellten Widerstandsbereichs des in Fig. 1 gezeigten Thyristors in Teilschnittansichten (A) - (D) zur Erläuterung von einer bevorzugten Ausführungsform des erfindungsgemäßen Verfahrens und einem weiteren Verfahren
Fig. 3 die den Teilschnittansichten (A) - (D) aus Fig. 2 entsprechenden Konzentrationsverläufe in jeweiligen Ansichten (A) - (D) zur Erläuterung der Verfahren.

In den unterschiedlichen Figuren sind gleiche Teile stets mit denselben Bezugszeichen versehen, so dass diese in der Regel auch nur einmal beschrieben werden.

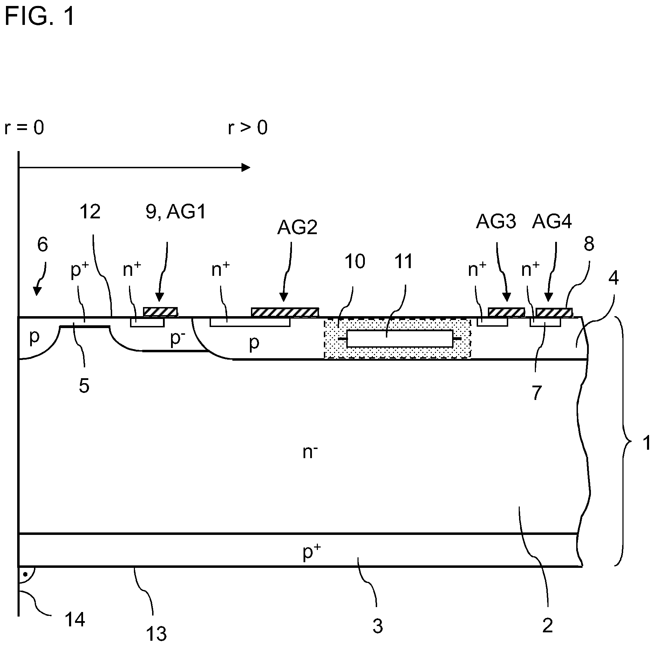

Figur 1 zeigt eine Teilschnittansicht eines lichtgezündeten Thyristors (LTT). Der Thyristor umfasst einen Halbleiterkörper 1, beispielsweise eine Siliziumscheibe, aus einem Halbleitermaterial 2 eines ersten Leitungstyps, in dem vorliegend beschriebenen Ausführungsbeispiel ein n⁻-dotiertes Halbleitermaterial 2. Anodenseitig ist in dem Halbleitermaterial 2 eine p⁺-dotierte Emitterzone 3 ausgebildet. Die Emitterzone 3 ist an der Scheibenrückseite großflächig über eine nicht dargestellte Anodenelektrode elektrisch kontaktiert. Kathodenseitig schließt sich eine Basiszone 4 eines zweiten, zum ersten Leitungstyp komplementären Leitungstyps an. In dem vorliegenden Ausführungsbeispiel ist die Basiszone 4 folglich p-dotiert. Die Basiszone 4 enthält eine Einschnürung 5, wobei die Basiszone 4 im zentralen Bereich 6 des Thyristors über ihre Geometrie einen Bereich mit reduzierter Durchbruchspannung definiert. Ein solcher Bereich mit reduzierter Durchbruchspannung ist dem Fachmann auch als BOD-Bereich bekannt. Kathodenseitig sind in der Basiszone 4 n⁺-dotierte Emitterzonen 7 eingebettet, die beispielsweise die Hilfsemitterzonen von Hilfsthyristoren sein können. Die Emitterzonen 7 werden durch Emitterelektroden 8 kontaktiert. Außerdem kontaktieren die Emitterelektroden 8 an der Außenseite auch die Basiszone 4.

Der in dem Teilschnitt in Figur 1 dargestellte Thyristor weist eine übliche Amplifying-Gate-Struktur auf, die die Amplifying-Gate-Stufen AG1, AG2, AG3 und AG4 umfasst, sowie ein kleines optisches Gate 9 und einen in einem Widerstandsbereich 10 angeordneten integrierten Lateralwiderstand 11. Bei der dargestellten Ausführungsform des lichtgezündeten Thyristors entspricht das optische Gate 9 der Amplifying-Gate-Stufe AG1. Der in Figur 1 dargestellte Thyristor ist über das Gate 9 optisch zündbar. Selbstverständlich ist die vorliegende Erfindung ebenso für elektrisch zündbare Thyristoren mit einer für die elektrische Zündung entsprechend gestalteten Amplifying-Gate-Stufe AG1 geeignet.

Wie Figur 1 zu entnehmen ist, befindet sich der Widerstandsbereich 10 bei dem dargestellten Thyristor in der p-dotierten Basiszone 4 zwischen zwei Hilfsemittern der Amplifying-Gate-Struktur und zwar zwischen der zweiten und der dritten Amplifying-Gate-Stufe AG2 und AG3. Der Widerstandsbereich 10 ist in Figur 1 als strichliniertes Rechteck gekennzeichnet. Innerhalb des Widerstandsbereichs 10 ist der Lateralwiderstand 11 angeordnet, der in Figur 1 mit einem entsprechenden Widerstandssymbol gekennzeichnet ist. Mit dem derart angeordneten, integrierten Lateralwiderstand 11 wird die Stromanstiegsgeschwindigkeit auf sinnvolle, das heißt insbesondere auf den Thyristor nicht zerstörende Werte beschränkt.

Die in Figur 1 gezeigte Anordnung des Widerstandsbereichs 10 bzw. Lateralwiderstands 11 ist selbstverständlich nicht einschränkend zu verstehen stellt lediglich eine beispielhafte Anordnung dar. Der Widerstandsbereich 10 und folglich der integrierte Lateralwiderstand 11 können zum Beispiel auch zwischen dem optischen Gate 9 und den nachfolgenden Amplifying-Gate-Stufen oder zwischen dem optischen Gate 9 und einer in Figur 1 nicht dargestellten Hauptkathode angeordnet sein. Ferner ist auch das Vorsehen eines weiteren Lateralwiderstands zusätzlich zu dem in Figur 1 dargestellten Lateralwiderstand 11 denkbar, beispielsweise zwischen dem optischen Gate 9 und der zweiten Amplifying-Gate-Stufe AG2. Eine solche Anordnung der als Strombegrenzungswiderstände vorgesehenen Lateralwiderstände bietet den wesentlichen Vorteil einer homogenen Zündausbreitung und vermag die Stromdichte in dem kleinen optischen Gate 9 bei einem sehr schnellen Stromanstieg auf einen den Thyristor nicht zerstörenden Wert zu begrenzen.

Der in Figur 1 dargestellte Thyristor ist vorzugsweise rotationssymmetrisch bezüglich der senkrecht auf den beiden Oberflächen 12 und 13 des Halbleiterkörpers 1 stehenden Achse 14 aufgebaut, die im zentralen Bereich 8 des Halbleiterbauelements verläuft. Die kathodenseitige Basiszone 4 und die Emitterzonen 7 sowie die entsprechenden Elektroden 8 und ferner der Widerstandsbereich 10 bzw. der Lateralwiderstand 11 sind in der Ebene der Oberfläche des Halbleiterkörpers 1 kreisförmig oder kreisringförmig ausgebildet. Der Thyristor ist bevorzugt ein Ringthyristor. Die dargestellten Formen der oben genannten Zonen und Schichten 4 bis 11 sind jedoch nicht zwingend. Sie können auch von der Kreisform bzw. Kreisringform abweichen und beispielsweise polygonal ausgebildet sein.

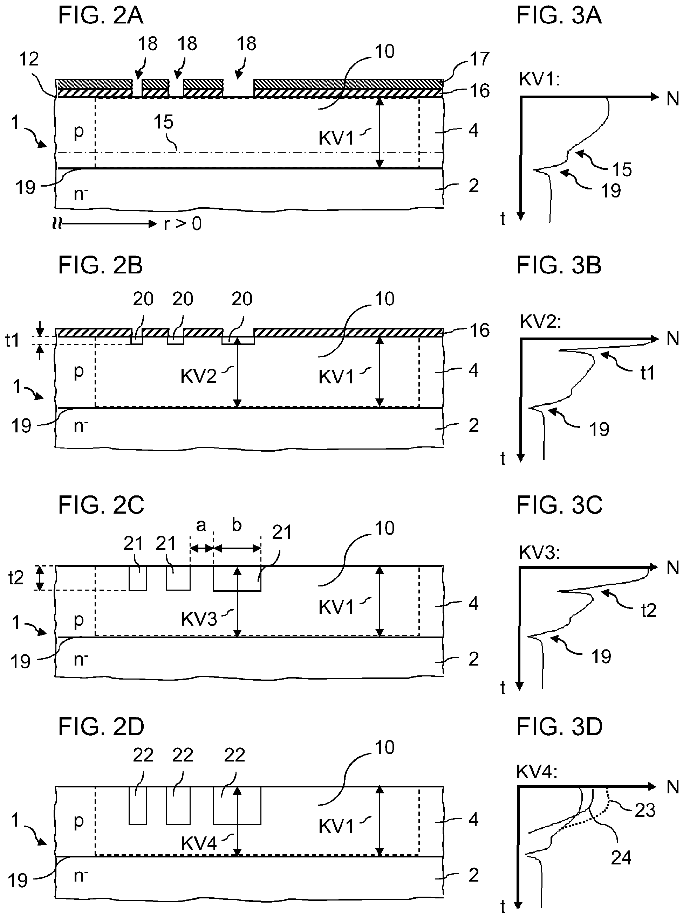

Nachfolgend werden nun anhand der Figuren 2 und 3 eine bevorzugte Ausführungsform des erfindungsgemäßen Verfahrens und ein weiteres, nicht erfindungsgemäßes Verfahren erläutert. Figur 2 stellt eine Serie von schematischen Ansichten (A) bis (D) dar, die den Ablauf des erfindungsgemäßen Herstellungsverfahrens am Beispiel von einem bevorzugten Ausführungsbeispiel und einem weiteren, nicht erfindungsgemäßen Beispiel erläutern. Figur 3 stellt in den Ansichten (A) bis (D) die zu den jeweiligen Ansichten aus Figur 2 entsprechenden Konzentrationsverläufe der Dotierstoffe im Halbleiterkörper dar, mit deren Hilfe das erfindungsgemäße Verfahren noch weiter verdeutlicht wird.

Figur 2A zeigt eine vergrößerte, schematische Teilschnittansicht des Widerstandsbereichs 10 des in Figur 1 dargestellten Thyristors. Der Widerstandsbereich 10, der in Figur 2A durch ein Rechteck mit strichlinierter Umfangslinie gekennzeichnet ist, befindet sich bei dem hier beschriebenen Ausführungsbeispiel des Halbleiterbauelements in der kathodenseitigen, p-dotierten Basiszone 4 des Halbleiterkörpers 1 zwischen der zweiten und dritten Amplifying-Gate-Stufe AG2 und AG3, wie Figur 1 zu entnehmen ist. Die p-dotierte Basiszone 4 wird beispielsweise durch eine Vorbelegung bzw. Dotierung von der Oberfläche 12 her mit Aluminiumatomen und einem oder mehreren nachfolgenden Eintreibschritten in den Halbleiterkörper 1 eindiffundiert. Die Tiefe des in die Basiszone 4 eingetriebenen Aluminium-Diffusionsprofils ist in Figur 2A durch eine Strichpunktlinie 15 angegeben. Die Aluminiumbelegung erfolgt typischerweise bei Belegtemperaturen im Bereich um etwa 1000 °C. Der oder die Eintreibschritte werden üblicherweise in oxidierender Atmosphäre bei Temperaturen über 1200 °C mehrere Stunden lang, beispielsweise etwa 5 h bis 10 h, durchgeführt.

Auf der Oberfläche 12 ist eine Maske 16 auf den Halbleiterköper 1 aufgetragen. Insbesondere handelt es sich bei der Maske 16 um ein thermisches bzw. thermisch erzeugtes Maskenoxid, beispielsweise SiO₂. Wie der Figur 2A zu entnehmen ist, wurde die Maske 16 bereits mit Hilfe eines auf die Maske 16 aufgetragenen Fotolacks 17 und nachfolgendem Entfernen der nicht von dem Fotolack 17 bedeckten Bereiche der Maske 16 derart strukturiert, dass drei Aussparungen 18 mit jeweils einer vorgegebenen Breite und einem vorgegebenen Abstand zueinander in die Maske 16 eingebracht wurden. Die Aussparungen 18 legen somit einen Teil des Widerstandsbereichs 10 an der Oberfläche 12 frei. Die in Figur 2A dargestellte Anzahl der Aussparungen 18 ist lediglich beispielhaft und keineswegs einschränkend zu verstehen. Selbstverständlich können sowohl noch weitere Aussparungen 18 in der Maske 16 im Widerstandsbereich 10 vorgesehen sein sowie auch weniger, beispielsweise lediglich eine Aussparung 18. Die Anzahl der in die Maske 16 eingebrachten Aussparungen 18 sowie deren jeweiligen Breiten und Abstände zueinander werden entsprechend dem in dem Widerstandsbereich 10 herzustellenden, gewünschten Lateralwiderstand 11 geeignet ausgewählt.

Figur 3A stellt den Konzentrationsverlauf der Dotierstoffe in dem Bereich des Halbleiterkörpers 1 dar, der in Figur 2A durch den Doppelpfeil KV1 gekennzeichnet ist. Die horizontale Achse gibt die Anzahl N der Dotierstoffe in der p-dotierten Basiszone 4 und in dem n⁻-dotierten Halbleitermaterial 2 in Abhängigkeit von der Tiefe t im Halbleiterkörper 1, die durch die vertikale Achse dargestellt wird, gemessen von der Oberfläche 12 an. Insbesondere stellt die in Figur 3A dargestellte Kurve in dem Bereich zwischen der Oberfläche 12 des Halbleiterkörpers 1 und dem pn-Übergang 19 zwischen der p-dotierten Basiszone 4 und dem n⁻-dotierten Halbleitermaterial 2 die Konzentration der in der Basiszone 4 vorhandenen Akzeptoren dar, wohingegen die Kurve in dem Bereich unterhalb des pn-Übergangs 19 die Konzentration der in dem Halbleitermaterial 2 vorhandenen Donatoren angibt.

Der Figur 3A ist zu entnehmen, dass die Konzentration der in der p-dotierten Basiszone 4 vorhandenen Akzeptoren von der Oberfläche 12 bis zur Strichlinie 15, die die Tiefe des in die Basiszone 4 eingetriebenen Aluminium-Diffusionsprofils angibt, allmählich abnimmt, um ab der Linie 15 für einen kurzen Bereich mit weiter zunehmender Tiefe t im Wesentlichen konstant zu verlaufen. Kurz vor dem pn-Übergang 19 nimmt die Konzentration der Akzeptoren in der p-dotierten Basiszone 4 schlagartig ab. Ab dem pn-Übergang 19 nimmt dann die Konzentration der Donatoren in dem n⁻-dotierten Halbleitermaterial 2 rasch zu, um mit weiter zunehmender Tiefe t annähernd konstant weiter zu verlaufen.

In Figur 2B ist der Halbleiterkörper 1 im Bereich des Widerstandsbereichs 10 nach dem Entfernen der Fotolackmaske 16 dargestellt. Des Weiteren wurde die durch die Aussparungen 18 freigelegte Oberfläche 12 des Halbleiterkörpers 1 im Widerstandsbereich 10 mit einem Dotierstoff des ersten Leitungstyps belegt, nämlich mit einem n-dotierenden Stoff. Bei diesem Belegungsschritt wird folglich in dem Widerstandsbereich 10 eine dünne n-dotierte Belegungsschicht 20 mit hoher Dotierungskonzentration an der Oberfläche ausgebildet.

Die dünne Belegungsschicht 20 kann beispielsweise durch eine (maskierten) Eindiffusion von als Donatoren wirksamen Atomen durchgeführt werden. Ein typischer n-dotierender Stoff ist zum Beispiel Phosphor, wobei die Eindiffusion dieser Phosphoratome relativ einfach in den Gesamtherstellungsprozess des Halbleiterbauelements integriert werden kann. Die Eindiffusion kann zum Beispiel mittels einer POCl3-Belegung oder einer Phosphin-Belegung mit einem oder mehreren nachfolgenden Eintreibschritten erfolgen. Die Vorbelegung erfolgt typischerweise bei Temperaturen über 1000 °C für eine Dauer von mehreren Stunden. Der Vorbelegungsschritt ist demnach ein so genannter Hochtemperaturschritt.

Werden die Akzeptoren der p-dotierten Basiszone 4 durch die Donatoren der Belegungsschicht 20 überkompensiert, entsteht, nicht erfindungsgemäß, ein pn-Übergang. Die Widerstandserhöhung im Widerstandsbereich 10 wird in diesem Falle durch den Schichtwiderstand der unterhalb der n-dotierten Belegungsschicht 20 liegenden p-dotierten Basiszone 4 bestimmt. Dieser Fall ist in Figur 2C dargestellt, wie später noch ausführlicher beschrieben wird.

Eine Alternative zur Eindiffusion der Belegungsschicht 20 in den Widerstandsbereich 10 der Basiszone 4 ist das Einbringen der Phosphoratome mittels einer (maskierten) Implantation bzw. Ionenimplantation. Da die Implantation im Gegensatz zur vorgenannten Vorbelegung mittels Diffusion kein Hochtemperaturprozess ist, kann sowohl thermisches SiO₂ als auch ein geeigneter Fotolack als Maske 16 dienen. Dies vereinfacht die bei der Vorbelegung sonst übliche Strukturierung der Maske 16 mittels des bei der Beschreibung der Figur 2A erwähnten fototechnischen Verfahrens, bei dem die Aussparungen 18 in die Maske 16 eingebracht werden.

Ein weiterer Vorteil der Implantation im Vergleich zu den bereits genannten Vorbelegungsverfahren (POCl3-Belegung oder Phosphin-Belegung) liegt in der genaueren Steuerung der einzubringenden Donatormenge in den Widerstandsbereich 10. Das kontrollierte Einbringen der Menge der Donatoren mittels Implantation ermöglicht es, nur einen Teil der in der Basiszone 4 vorhandenen Akzeptoren zu kompensieren (Teilkompensation). In diesem Fall erhöht sich der Schichtwiderstand in den durch die Donatoren dotierten Bereichen 21 bzw. 22, die in den Figuren 2C bzw. 2D dargestellt sind, ohne dass sich ein pn-Übergang bilden muss. Der erfindungsgemäße Fall, dass kein pn-Übergang gebildet wurde, ist in Figur 2D dargestellt und wird weiter unten ausführlich beschrieben.

Figur 3B stellt den Konzentrationsverlauf der Dotierstoffe in dem Bereich des Halbleiterkörpers 1 dar, der in Figur 2B durch den Doppelpfeil KV2 gekennzeichnet ist. Die in Figur 2B dargestellte Belegungsschicht 20 sei in diesem Beispiel des nicht erfindungsgemäßen Verfahrens mittels einer Phosphorbelegung bzw. Phosphordiffusion, beispielsweise durch eine POCl3-Belegung oder eine Phosphin-Belegung wie zuvor beschrieben erzeugt worden. Die als Donatoren wirksamen Phosphoratome überkompensieren in dieser Ausführungsform die in der Basiszone 4 bzw. dem Widerstandsbereich 10 vorhandenen Akzeptoren, wodurch es zur Bildung eines pn-Übergangs zwischen der n-dotierten Belegungsschicht 20 und der p-dotierten Basiszone 4 kommt. In dem in Figur 3B dargestellten Konzentrationsverlauf ist dieser pn-Übergang in der Tiefe t1 deutlich zu erkennen.

Insbesondere stellt die in Figur 3B gezeichnete Kurve in dem Bereich zwischen der Oberfläche 12 des Halbleiterkörpers 1 und dem in der Tiefe t1 liegenden pn-Übergang zwischen der n-dotierten Belegungsschicht 20 und der p-dotierten Basiszone 4 die Konzentration der in der Belegungsschicht 20 vorhandenen Donatoren dar. Deutlich ist in Figur 3B eine sehr hohe Donatorkonzentration zu erkennen, die bis zu dem pn-Übergang in der Tiefe t1 sehr rasch abnimmt. In diesem Bereich liegt eine Überkompensation der in der p-dotierten Basiszone 4 vorhandenen Akzeptoren durch die eingebrachten Donatoren vor. Zwischen dem pn-Übergang in der Tiefe t1 und dem pn-Übergang 19 stellt die Kurve die Konzentration der in der der Basiszone 4 vorhandenen Akzeptoren dar, die im bereich des pn-Übergangs in der Tiefe t1 aufgrund der Überkompensation durch die Donatoren der Belegungsschicht 20 zunächst sehr gering ist, mit zunehmendem Abstand in Richtung größerer Tiefe t rasch zunimmt, um dann mit weiter zunehmender Tiefe t in Richtung des pn-Übergangs 19 dem bereits in Figur 3A beschriebenen Verlauf zu folgen.

In Figur 2C ist das Ergebnis des Eintreibschritts des nicht erfindungsgemäßen Verfahrens dargestellt. Aus der dünnen Belegungsschicht 20 mit einer hohen Dotierungskonzentration wird bei diesem Schritt eine dickere Schicht 21 bzw. eine Widerstandsschicht 21 mit geringerer Dotierungskonzentration gebildet. Insbesondere weist die Schicht 21 nach dem Eintreibschritt eine Tiefe t2 auf, die größer ist als die Tiefe t1 vor dem Eintreibschritt. Wie der Konzentrationskurve in Figur 3C zu entnehmen ist, liegt in dem Bereich zwischen der Oberfläche 12 und der Tiefe t2 nach wie vor eine Überkompensation der in der Schicht 21 bzw. in der Basiszone 4 vorhandenen Akzeptoren durch die in die Schicht 21 eingebrachten Donatoren vor. Der Widerstand wird in dem dargestellten Fall bestimmt durch den Schichtwiderstand der p-dotierten Basiszone 4 unterhalb des pn-Übergangs in der Tiefe t2. In Figur 3C ist dieser Bereich durch den Konzentrationsverlauf KV3 zwischen den mit Pfeilen markierten Punkten t2 und 19 dargestellt.

Die Widerstandshöhe des gesamten Lateralwiderstands 10 wird demnach bei dem nach dem nicht erfindungsgemäßen Verfahren hergestellten Halbleiterbauelement bestimmt durch die Anzahl der in den Widerstandsbereich 10 eingebrachten Schichten 21, deren jeweiligen Breiten b und deren Abstände a zueinander sowie die jeweiligen Tiefen t2 im Widerstandsbereich 10.

Besonders vorteilhaft werden die in Figur 2C dargestellten Schichten 21 mit unterschiedlichen Breiten hergestellt, insbesondere nimmt die Breite der jeweiligen Schichten 21 mit zunehmendem Radius r zu. Die Breite kann jedoch auch mit zunehmendem Radius r abnehmen. Diese Ausführung ermöglicht es, den Lateralwiderstand 11 in radialer Richtung derart einzustellen, dass zum Beispiel die im Widerstand dissipierte Verlustleistung gleichmäßig über den gesamten radialen Widerstandsbereich verteilt wird. Dies führt zu einer besonders homogenen Zündausbreitung und begrenzt die Stromdichte in dem kleinen optischen Gate 9 bei einem sehr schnellen Stromanstieg auf einen den Thyristor nicht zerstörenden Wert, wie bereits beschrieben wurde.

In Figur 2D ist das Ergebnis des Eintreibschritts einer bevorzugten Ausführungsform des erfindungsgemäßen Verfahrens dargestellt. Die Ausführungsform unterscheidet sich von dem ersten, bisher beschriebenen nicht erfindungsgemäßen Verfahren darin, dass anstelle einer Phosphorbelegung die Phosphoratome mittels einer Ionenimplantation in den freigelegten Widerstandsbereich 10 eingebracht werden. Das Belegen des freigelegten Widerstandsbereichs 10, so dass eine dünne Belegungsschicht 20 mit hoher Dotierungskonzentration gebildet wird, mittels einer Implantation ist in den Figuren nicht dargestellt, erfolgt jedoch im Wesentlichen analog zu dem in Figur 2B beschriebenen Fall. Da jedoch mit Hilfe der Implantation das Einbringen der Donatormenge zur Bildung der dünnen Belegungsschicht 20 an dem freigelegten Widerstandsbereich 10 wesentlich kontrollierter erfolgt und nur ein Teil der in dem Widerstandsbereich 10 bzw. der Basiszone 4 vorhandenen Akzeptoren durch die eingebrachten Donatoren kompensiert wird (Teilkompensation), bildet sich bei der Ausführungsform des erfindungsgemäßen Verfahrens kein pn-Übergang zwischen der n-dotierten Belegungsschicht 20 und der p-dotierten Basiszone 4.

Nachdem durch Implantation die dünne Belegungsschicht 20 mit hoher Dotierungskonzentration gebildet wurde, werden die Donatoren in dem nachfolgenden Eintreibschritt in den Widerstandsbereich 10 eingetrieben und bilden die in Figur 2D dargestellte dickere Schicht 22 bzw. Widerstandsschichten 22. Die anfängliche Akzeptorkonzentration 23 der Basiszone 4, die in Figur 3D durch eine punktierte Kurve 23 dargestellt ist, wird durch die eindiffundierten Donatoren, deren unkompensiertes Donatorprofil 24 in Figur 3D ebenfalls durch eine separate Kurve dargestellt ist, teilweise kompensiert, wie aus der in Figur 3D dargestellten aus den Kurven 23 und 24 resultierenden Kurve zu entnehmen ist.

Die Widerstandshöhe des gesamten Lateralwiderstands 10 wird bei dem nach der Ausführungsform hergestellten Halbleiterbauelement bestimmt durch die Anzahl der in den Widerstandsbereich 10 eingebrachten Widerstandsschichten 22, deren jeweiligen Breiten b, deren jeweiligen Abstände a zueinander und die jeweiligen Tiefen im Widerstandsbereich 10 sowie die Menge der nicht kompensierten Akzeptoren in der Widerstandsschicht 22.

Besonders vorteilhaft werden die in Figur 2D dargestellten Schichten 22 erfindungsgemäß mit unterschiedlichen Breiten hergestellt, insbesondere nimmt die Breite der jeweiligen Schicht 22 mit zunehmenden Radius r zu. Diese Ausführung ermöglicht es, den Lateralwiderstand 11 in radialer Richtung derart einzustellen, dass zum Beispiel die im Widerstand dissipierte Verlustleistung gleichmäßiger über den gesamten radialen Widerstandsbereich verteilt wird. Dies führt zu einer besonders homogenen Zündausbreitung und begrenzt die Stromdichte in dem kleinen optischen Gate 9 bei einem sehr schnellen Stromanstieg auf einen den Thyristor nicht zerstörenden Wert, wie bereits beschrieben wurde.

Phosphor weist eine relativ geringe Diffusionskonstante auf. Dies ist bei der Verwendung von Phosphor als Donator zu berücksichtigen, insbesondere wenn tiefe Diffusionsprofile mit einem flachen Konzentrationsgradienten gewünscht sind. In diesem Falle ist es beispielsweise möglich, die Phosphordiffusion so früh wie möglich im Laufe der Hochtemperaturprozesse zur Herstellung des Halbleiterbauelements durchzuführen, um eine ausreichende Eindringtiefe bzw. einen flachen Konzentrationsgradienten und damit auch die gewünschte Erhöhung des Querwiderstandes in der p-dotierten Basiszone bzw. Widerstandsbereich in ausreichendem Maße und damit einen gewünschten integrierten Lateralwiderstand zu erzielen. Eine mögliche Variation des erfindungsgemäßen Verfahrens ist beispielsweise, die Phosphorbelegung zum Beispiel direkt vor dem ersten Eintreibschritt der mit Aluminiumatomen vorbelegten Basiszone durchzuführen. Ebenso könnte der erste Eintreibschritt der Aluminiumatome nach einer geeigneten Zeitdauer unterbrochen und nach der Phosphorbelegung und einem zusätzlichen Eintreibschritt wieder fortgesetzt werden.

Eine weitere Möglichkeit, die geringe Diffusionskonstante der Phosphoratome zu umgehen, besteht darin, anstelle von Phosphoratomen beispielsweise Selenatome in den Widerstandsbereich einzubringen. Selen weist eine wesentlich höhere Diffusionskonstante als Phosphor auf. Das Einbringen der Selenatome in den Widerstandsbereich kann sowohl durch eine maskierte Diffusion aus der Gasphase als auch durch eine maskierte Ionenimplantation erfolgen. Daran schließt sich wie zuvor beschrieben ein Eintreibschritt bei ausreichend hoher Temperatur an, um die mit Selenatomen erzeugte Belegungsschicht in den Widerstandsbereich einzutreiben. Als Maske kann bei der Belegung bzw. Diffusion des Widerstandsbereichs und auch bei der Implantation mit Selenatomen thermisch erzeugtes SiO₂ als Maskenoxid verwendet werden.

Ein weiterer Vorteil bei der Verwendung von Selenatomen als Donatoren anstelle von Phosphoratomen liegt darin, dass einerseits die Löslichkeit der Selenatome in einem Bereich liegt, der, nicht erfindungsgemäß, eine Überkompensation der in der p-dotierten Basiszone vorhandenen Aluminiumatome problemlos ermöglicht und anderseits auch nur eine geringe Überkompensation der p-dotierenden Aluminiumatome auftritt, da Selen aufgrund seiner speziellen Eigenschaften als so genannter Doppeldonator mit zwei relativ tief in der Energielücke von Silizium liegenden Energieniveaus die in der Basiszone vorhandene p-Dotierung einerseits vollständig überkompensiert, die überschüssigen Selenatome aber andererseits lediglich zu einem gewissen Prozentsatz, der von der Temperatur abhängig ist, aktiviert sind. Letzteres bringt eine höhere Robustheit des Halbleiterbauelements gegenüber unerwünschten parasitären Effekten, wie zum Beispiel Oberflächenkanäle, mit sich. Ferner ist es erfindungsgemäß auch mittels der Selenatome anstelle einer Überkompensation nur eine Teilkompensation im Widerstandsbereich durchzuführen. Die Kombination der Selenbelegung mit der Phosphorbelegung zur Einbringung von Donatoren in den Widerstandsbereich ist ebenso möglich.

Durch das erfindungsgemäße Verfahren lassen sich Halbleiterbauelemente mit einem integrierten Lateralwiderstand herstellen, wobei jegliche Ätzstufen bzw. Ätzkanten bei der Herstellung des Lateralwiderstands vermieden werden. Hierdurch lassen sich wesentliche kleinere Widerstandsstrukturen im Widerstandsbereich realisieren. Diese liegen beispielsweise deutlich unter 30 µm. Die kleiner realisierbaren Widerstandsstrukturen ermöglichen wiederum ein genaueres Einstellen des Lateralwiderstands in radialer Richtung, wodurch sich ein gewünschter differentieller Widerstand zum Beispiel in radialer Richtung gleichmäßig und genau einstellen lässt.

Die Erfindung sei nicht auf das in den Figuren 1 bis 3 dargestellte Ausführungsbeispiel beschränkt. Vielmehr können dort beispielsweise durch Austauschen der Leitfähigkeitstypen n gegen p und umgekehrt sowie durch Variation der Dotierungskonzentrationen eine Vielzahl neuer Varianten angegeben werden. Die vorstehend beschriebenen Verfahren zur Herstellung eines Halbleiterbauelements mit integriertem Lateralwiderstand können auch kombiniert werden und lassen sich sowohl auf n- als auch auf p-leitende Widerstandsbereiche anwenden. So lassen sich beispielsweise das Einbringen von Donatoren mittels Phosphor in den Widerstandsbereich und das Einbringen von Donatoren mittels Selen in den Widerstandsbereich miteinander kombinieren.

Ferner kann anstelle von Silizium als Grundmaterial für den Halbleiterkörper auch jedes andere geeignete Halbleitermaterial, beispielsweise Siliziumkarbid oder Galliumarsenid, als Grundmaterial vorgesehen werden.

Ebenso ist die in den Figuren 2C und 2D dargestellte Anzahl der Widerstandsschichten 21 bzw. 22, deren jeweiligen Breiten b, deren jeweiligen Abständen a zueinander oder deren Tiefen nicht auf die den Figuren 2C und 2D zu entnehmenden Darstellungen beschränkt. So können die Breiten b jeweils für die Widerstandsschichten 21 bzw. 22 gleich oder verschieden gewählt werden. Gleiches gilt für die Abstände a der Schichten 21 bzw. 22 zueinander. So können diese jeweils gleich oder verschieden gewählt werden. Auch die Tiefen der Schichten 21 bzw. 22 im Widerstandsbereich 10 können für alle Schichten 21 bzw. 22 jeweils gleich oder verschieden gewählt werden. Letzteres wäre beispielsweise durch Einbringen bzw. Eintreiben von Donatoren mit unterschiedlichen Diffusionskonstanten denkbar.

Grundsätzlich kann das beschriebene Verfahren zur Realisierung jeder Art von Halbleiterbauelement mit integriertem Lateralwiderstand verwendet werden. Erfindungsgemäß wird das Verfahren zur Herstellung von Thyristoren und insbesondere von lichtgezündeten Thyristoren (LTT) verwendet. Bei einem lichtgezündeten Thyristor ist beispielsweise das Integrieren eines lateralen, radialsymmetrischen Strombegrenzungswiderstands zwischen dem optischen Gate und den nachfolgenden Amplifying-Gate-Stufen oder der Hauptkathode und/oder zwischen der zweiten und dritten Amplifying-Gate-Stufe besonders bevorzugt, um eine homogene Zündausbreitung zu gewährleisten und die Stromdichte in dem kleinen optischen Gate bei einem sehr schnellen Stromanstieg auf einen den Thyristor nicht zerstörenden Wert zu begrenzen.

### Bezugszeichenliste

- 1: Halbleiterkörper
- 2: n⁻-dotiertes Halbleitermaterial
- 3: Anodenseitige Emitterzone
- 4: Kathodenseitige p-dotierte Basiszone
- 5: Aussparung
- 6: Zentraler Bereich, BOD-Bereich
- 7: Kathodenseitige Emitterzonen, Hilfsemitterzonen
- 8: Emitterelektroden
- 9: Optisches Gate
- 10: Widerstandsbereich
- 11: Integrierter Lateralwiderstand
- 12: Oberfläche, Scheibenoberseite
- 13: Oberfläche, Scheibenrückseite
- 14: Achse
- 15: Tiefe Aluminium-Diffusionsprofil
- 16: Maske, Maskenoxid
- 17: Fotolack
- 18: Aussparung
- 19: pn-Übergang
- 20: Dünne n-dotierte Belegungsschicht
- 21: Widerstandsschicht bei Überkompensation
- 22: Widerstandsschicht bei Teilkompensation
- 23: Anfängliche Akzeptorkonzentration
- 24: Nicht kompensiertes Donatorprofil

- a: Abstand
- b: Breite
- AG1-AG4: Amplifying-Gate-Stufen
- KV1-KV4: Konzentrationsverläufe
- N: Anzahl der Dotierstoffatome
- r: Radius
- t, t1, t2: Tiefe im Halbleiterkörper 1

## Patentansprüche

1. Verfahren zur Herstellung eines Thyristors mit wenigstens einem integrierten Lateralwiderstand (11) mit folgenden Schritten:
- Bereitstellen eines Halbleiterkörpers (1) aus einem dotierten Halbleitermaterial eines ersten Leitungstyps (n) mit einer an eine Oberfläche des Halbleiterkörpers (1) angrenzenden, dotierten Basiszone (4) eines zweiten, zum ersten Leitungstyp komplementären Leitungstyps (p),
- Maskieren der Oberfläche des Halbleiterkörpers (1), wobei wenigstens eine Aussparung (18) mit einer vorgegebenen Breite in die Maske (16) eingebracht wird, so dass ein Widerstandsbereich (10) der Basiszone (4) wenigstens teilweise freigelegt wird,
- Belegen des freigelegten Widerstandsbereichs (10) mit einem Dotierstoff des ersten Leitungstyps (n) derart, dass oberflächenseitig an dem freigelegten Widerstandsbereich (10) eine dünne Belegungsschicht (20) des ersten Leitungstyps (n) mit hoher Dotierungskonzentration gebildet wird,
- Eintreiben des belegten Dotierstoffs des ersten Leitungstyps (n) in den Widerstandsbereich (10) derart, dass aus der dünnen Belegungsschicht (20) mit hoher Dotierungskonzentration eine dickere Schicht (21, 22) mit geringerer Dotierungskonzentration gebildet wird,
**dadurch gekennzeichnet, dass**
die Dotierung der Basiszone (4) des zweiten Leitungstyps (p) in dem Widerstandsbereich (10) lediglich teilweise von dem eingetriebenen Dotierstoff des ersten Leitungstyps (n) kompensiert wird.

2. Verfahren nach Anspruch 1, wobei die dünne Belegungsschicht (20) des ersten Leitungstyps (n) mit hoher Dotierungskonzentration durch Diffusion in den Widerstandsbereich (10) der Basiszone (4) des zweiten Leitungstyps (p) erzeugt wird.

3. Verfahren nach Anspruch 1, wobei die dünne Belegungsschicht (20) des ersten Leitungstyps (n) mit hoher Dotierungskonzentration durch Implantation in den Widerstandsbereich (10) der Basiszone (4) des zweiten Leitungstyps erzeugt wird.

4. Verfahren nach einem der vorhergehenden Ansprüche, wobei die Belegung der dünnen Belegungsschicht (20) des ersten Leitungstyps mit Phosphor und/oder Selen erfolgt.

5. Verfahren nach einem der vorhergehenden Ansprüche, wobei mehrere Aussparungen (18) jeweils mit einer vorgegebenen Breite und in einem vorgegebenen Abstand zueinander in die Maske (16) eingebracht werden.

6. Verfahren nach Anspruch 5, wobei die Breite der jeweiligen Aussparungen (18) mit zunehmendem Radius (r) zu- oder abnimmt.

7. Verfahren nach einem der vorhergehenden Ansprüche, wobei das Maskieren der Oberfläche des Halbleiterkörpers (1) mittels eines Maskenoxids und/oder eines Fotolacks erfolgt.

## Claims

1. Method for producing a thyristor having at least one integrated lateral resistor (11) comprising the following steps:
- providing a semiconductor body (1) made of a doped semiconductor material of a first conduction type (n) having a doped base zone (4) of a second conduction type (p) complementary to the first conduction type, said base zone adjoining a surface of the semiconductor body (1),
- masking the surface of the semiconductor body (1), wherein at least one recess (18) having a prescribed width is introduced into the mask (16) so that a resistor region (10) of the base zone (4) is at least partly exposed,
- depositing a dopant of the first conduction type (n) on the exposed resistor region (10) in such a way that a thin deposition layer (20) of the first conduction type (n) with a high doping concentration is formed on the surface of the exposed resistor region (10),
- collecting the deposited dopant of the first conduction type (n) in the resistor region (10) in such a way that a thicker layer (21, 22) with a lower doping concentration is formed from the thin deposition layer (20) with a high doping concentration,
**characterized in that**
the doping of the base zone (4) of the second conduction type (p) in the resistor region (10) is compensated only partly by the collected dopant of the first conduction type (n).

2. Method according to Claim 1, wherein the thin deposition layer (20) of the first conduction type (n) with a high doping concentration is produced by diffusion into the resistor region (10) of the base zone (4) of the second conduction type (p).

3. Method according to Claim 1, wherein the thin deposition layer (20) of the first conduction type (n) with a high doping concentration is produced by implantation into the resistor region (10) of the base zone (4) of the second conduction type.

4. Method according to one of the preceding claims, wherein the deposition of the thin deposition layer (20) of the first conduction type takes place using phosphorus and/or selenium.

5. Method according to one of the preceding claims, wherein a plurality of recesses (18) each having a prescribed width and at a prescribed distance from one another are introduced into the mask (16).

6. Method according to Claim 5, wherein the width of the respective recesses (18) increases or decreases as the radius (r) increases.

7. Method according to one of the preceding claims, wherein the masking of the surface of the semiconductor body (1) takes place by means of a mask oxide and/or a photoresist.

## Revendications

1. Procédé de fabrication d'un thyristor comportant au moins une résistance latérale intégrée (11), comprenant les étapes suivantes
- la préparation d'un corps semi-conducteur (1) à partir d'un matériau semi-conducteur dopé d'un premier type de conductivité (n), comportant une zone de base dopée (4) d'un second type de conductivité (p) complémentaire du premier type de conductivité adjacente à une surface du corps semi-conducteur (1),
- le masquage de la surface du corps semi-conducteur (1), au moins un évidement (18) d'une largeur prédéfinie étant réalisé dans le masque (16), de sorte qu'une zone de résistance (10) de la zone de base (4) soit au moins partiellement exposée,
- le dépôt sur la zone de résistance (10) exposée d'un dopant du premier type de conductivité (n) de telle sorte qu'une couche de dépôt mince (20) du premier type de conductivité (n) présentant une concentration de dopage élevée soit formée côté surface sur la zone de résistance (10) exposée,
- l'introduction dans la zone de résistance (10) du matériau de dopage n déposé du premier type de conductivité (n) de telle sorte qu'une couche plus épaisse (21, 22) présentant une moindre concentration de dopage soit formée à partir de la couche de dépôt mince (20),
**caractérisé en ce que** le dopage de la zone de base (4) du second type de conductivité (p) dans la zone de résistance (10) n'est que partiellement compensé par le matériau de dopage introduit du premier type de conductivité (n).

2. Procédé selon la revendication 1, dans lequel la couche de dépôt mince (20) du premier type de conductivité (n) présentant une concentration de dopage élevée est produite par diffusion dans la zone de résistance (10) de la zone de base (4) du second type de conductivité (p).

3. Procédé selon la revendication 1, dans lequel la couche de dépôt mince (20) du premier type de conductivité (n) présentant une concentration de dopage élevée est produite par implantation dans la zone de résistance (10) de la zone de base (4) du second type de conductivité.

4. Procédé selon l'une des revendications précédentes, **caractérisé en ce que** le dépôt sur la couche de dépôt mince (20) du premier type de conductivité est effectué avec du phosphore et/ou du sélénium.

5. Procédé selon l'une des revendications précédentes, dans lequel une pluralité d'évidements (18) sont réalisés dans le masque (16), chacun avec une largeur prédéterminée et à une distance prédéterminée les uns des autres.

6. Procédé selon la revendication 5, dans lequel la largeur des évidements respectifs (18) augmente ou diminue lorsque le rayon (r) augmente.

7. Procédé selon l'une des revendications précédentes, dans lequel le masquage de la surface du corps semi-conducteur (1) est effectué au moyen d'un oxyde de masquage et/ou d'une photoréserve.
